# EUROPEAN PATENT APPLICATION

(11) **EP 2 763 316 A1**
(43) Date of publication of application: **06.08.2014**
(21) Application number: 12835342.2
(22) Date of filing: 26.09.2012
(51) Int. Cl.: H03K 7/08, H03F 3/217

(54) **SIGNAL SYNTHESIS CIRCUIT, DIGITAL AUDIO AMPLIFIER, AND POWER SUPPLY CIRCUIT**

(30) Priority: 26.09.2011 JP 2011209379
(71) Applicant: NEC Corporation, Tokyo 108-8001 (JP)
(72) Inventor: TAKAHASHI, Kiyohiko, Tokyo 108-8001 (JP)
(74) Representative: Vossius & Partner
(86) International application number: PCT/JP2012/074631
(87) International publication number: WO 2013/047550

(57) **Abstract**

A signal synthesis circuit includes a slope generation circuit that receives a first 1-bit digital signal as an input, generates a slope on the first 1-bit digital signal during at least one of a time period of transition of the first 1-bit digital signal from high to low and a time period of transition of the first 1-bit digital signal from low to high, and outputs a resultant signal, and a 1-bit decision circuit that receives an analog signal and an output signal of the slope generation circuit as inputs, varies a high-low decision on the output signal of the slope generation circuit by using the analog signal, and outputs a second 1-bit digital signal generated by the high-low decision.

## Description

### {Technical Field}

The present invention relates to a signal synthesis circuit, a digital audio amplifier, a power supply circuit, a signal synthesis method in the signal synthesis circuit, a drive method for the digital audio amplifier, and a drive method for the power supply circuit. In particular, the present invention relates to a technique concerning a circuit configuration for performing addition or subtraction of a digital signal and an analog signal in an electronic circuit for carrying out an operation, a signal synthesis method or a drive method in the circuit.

### {Background Art}

A circuit having a mixture of an analog signal processing unit and a digital signal processing unit is used in devices for various uses. As an example of the analog-digital mixture circuit, there is a digital audio amplifier having a D-class amplifier in an output stage.

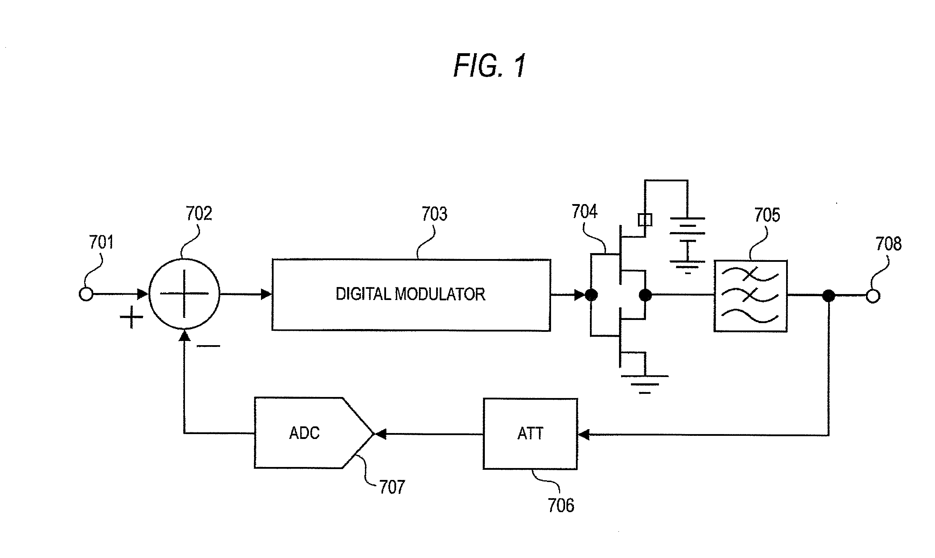

Fig. 1 is a block diagram illustrating one configuration example of a digital audio amplifier of the related art. As illustrated in Fig. 1, a digital audio amplifier includes a digital audio signal input terminal 701, a digital subtracter 702, a digital modulator 703, a D-class amplifier 704, a low-pass filter 705, an attenuator 706, an analog-digital converter 707, and an analog audio signal output terminal 708.

A digital audio signal input to the digital audio signal input terminal 701 is output to the digital subtracter 702. The digital subtracter 702 subtracts a digital signal output by the analog-digital converter 707 from the digital audio signal, and outputs a digital signal obtained by the subtraction to the digital modulator 703. The digital modulator 703 converts the output signal of the digital subtracter 702 to a 1-bit pulse pattern and outputs the 1-bit pulse pattern to the D-class amplifier 704. The D-class amplifier 704 amplifies the 1-bit pulse pattern output by the digital modulator 703 and outputs the amplified 1-bit pulse pattern to the low-pass filter 705. The low-pass filter 705 removes high frequency noise components from the output signal of the D-class amplifier 704, and outputs a resultant signal to the analog audio signal output terminal 708 and the attenuator 706.

The attenuator 706 attenuates the output signal of the low-pass filter 705 with a preset ratio, and outputs a resultant signal to the analog-digital converter 707. The analog-digital converter 707 converts the output signal of the attenuator 706 to a digital signal and outputs the digital signal to the digital subtracter 702. The signal output to the analog audio signal output terminal 708 is output to an external load such as a speaker.

In the digital audio amplifier illustrated in Fig. 1, the digital modulator 703 is a 1-bit digital modulator such as a PWM (Pulse Width Modulation) modulator or a delta sigma modulator. The output signal of the digital modulator 703 is a 1-bit digital signal; however, if high frequency noise components are removed from the output signal, the digital signal is demodulated as an analog audio signal. Therefore, each of the signal output from the analog audio signal output terminal 708 and the signal input to the analog-digital converter 707 via the attenuator 706 is an analog signal.

As described heretofore, the digital audio amplifier illustrated in Fig. 1 is an analog-digital mixture circuit that receives a digital signal as an input signal and outputs an analog signal as an output signal.

As for techniques relating to the present invention, there is description concerning a digital audio amplifier that receives a digital signal as an input in PTL 1. There is description concerning D-class amplification processing for amplifying a pulse signal in PTL 2. There is description concerning a digital signal converter in PTL 3.

### {Citation List}

### {Patent Literature}

{PTL 1} JP-A-2006-191250
{PTL 2} JP-A-2010-268211
{PTL 3} JP-A-2009-531932

### {Summary of Invention}

### {Technical Problem}

The analog-digital mixture circuit typified by the digital audio amplifier has a problem described hereafter.

The problem is that all of a plurality of numerical values to be computed when conducting computation processing such as addition or subtraction must be digital signals or analog signals. This is caused by that a conventional adder or subtracter can perform computation only between analog signals or between digital signals. This means that a large number of analog-digital converters or a large number of digital-analog converters become necessary in the analog-digital mixture circuit. However, an increase of dissipation power and enlargement of circuit scale in the analog-digital mixture circuit become tend to occur by mounting a large number of analog-digital converters or a large number of digital-analog converters.

An exemplary object of the present invention is to provide a circuit that performs addition or subtraction between an analog signal and a digital signal without using an analog-digital converter or a digital-analog converter, and a signal synthesis method and a drive method in the circuit.

### {Solution to Problem}

According to a first aspect of the present invention, there is provided a signal synthesis circuit including:
a slope generation circuit that receives a first 1-bit digital signal as an input, generates a slope on the first 1-bit digital signal during at least one of a time period of transition of the first 1-bit digital signal from high to low and a time period of transition of the first 1-bit digital signal from low to high, and outputs a resultant signal; and
a 1-bit decision circuit that receives an analog signal and an output signal of the slope generation circuit as inputs, varies a high-low decision on the output signal of the slope generation circuit by using the analog signal, and outputs a second 1-bit digital signal generated by the high-low decision,
a duty ratio of the first 1-bit digital signal being varied based on the analog signal and the second 1-bit digital signal being output.

According to a second aspect of the present invention, there is provided a digital audio amplifier including:
a digital modulator that converts an input signal to a third 1-bit digital signal; and
a power amplification circuit block that amplifies an output signal of the digital converter, wherein
the power amplification circuit block includes:
   an attenuator;
   a signal synthesizer that combines the third 1-bit digital signal with an output signal of the attenuator and outputs a resultant synthesized signal;
   a D-class amplifier that amplifies an output signal of the signal synthesizer; and
   a low-pass filter that removes high frequency noise components from an output signal of the D-class amplifier and outputs a resultant signal,
   the attenuator detecting an output signal of the low-pass filter, attenuating the output signal with a preset ratio, and outputting a resultant signal to the signal synthesizer,
   the signal synthesizer being a signal synthesis circuit according to any one of claims 1 to 6,
   the third 1-bit digital signal being input as the first 1-bit digital signal, and
   an output signal of the attenuator being input as the analog signal.

According to a third aspect of the present invention, there is provided a power supply circuit including:
a digital modulator that receives a first distributed signal obtained by separating an input signal as an input and converts the first distributed signal to a third 1-bit digital signal;
a power amplification circuit block that receives a signal obtained by delaying a second distributed signal obtained by separating the input signal and the third 1-bit digital signal as inputs, amplifies the second distributed signal and the third 1-bit digital signal, then performs power synthesis, and outputs a resultant signal; and
a delay unit that provides the second distributed signal with a time delay as compared with the first distributed signal and outputs a resultant signal to the power amplification circuit block as the signal,
the power amplification circuit block including:
a linear amplifier that receives the delayed second distributed signal as an input, amplifies the delayed second distributed signal, and outputs a resultant signal;
a high-pass filter that receives an output signal of the linear amplifier as an input, removes low frequency components, and outputs a resultant signal;
a current detector that detects a current component from an output signal of the high-pass filter, and outputs the current components;
a first low-pass filter that receives an output signal of the current detector, removes high frequency components, and outputs a resultant signal;
a signal synthesizer that receives the third 1-bit digital signal and an output signal of the first low-pass filter as inputs, combines them, and outputs a resultant synthesized signal;
a switching amplifier that amplifies the output signal of the signal synthesizer; and
a second low-pass filter that removes high frequency noise components from an output signal of the switching amplifier, and outputs a resultant signal,
the signal synthesizer being the signal synthesis circuit according to any one of claims 1 to 6,
the third 1-bit digital signal being input as the first 1-bit digital signal,
an output signal of the first low-pass filter being input as the analog signal,
a cutoff frequency of the high-pass filter being lower in frequency than a cutoff frequency of the second low-pass filter, and
an output signal of the second low-pass filter and the output signal of the high-pass filter being subject to power synthesis and a resultant signal being output.

Fourth, fifth and sixth exemplary aspects according to the present invention are a signal synthesis method in a signal synthesis circuit, a digital audio amplifier drive method, and a power supply circuit drive method.

### {Advantages Effects of the Invention}

According to the present invention, it is possible to provide a circuit that performs addition or subtraction between an analog signal and a digital signal with a simple circuit configuration without using an analog-digital converter or a digital-analog converter.

### {Brief Description of Drawings}

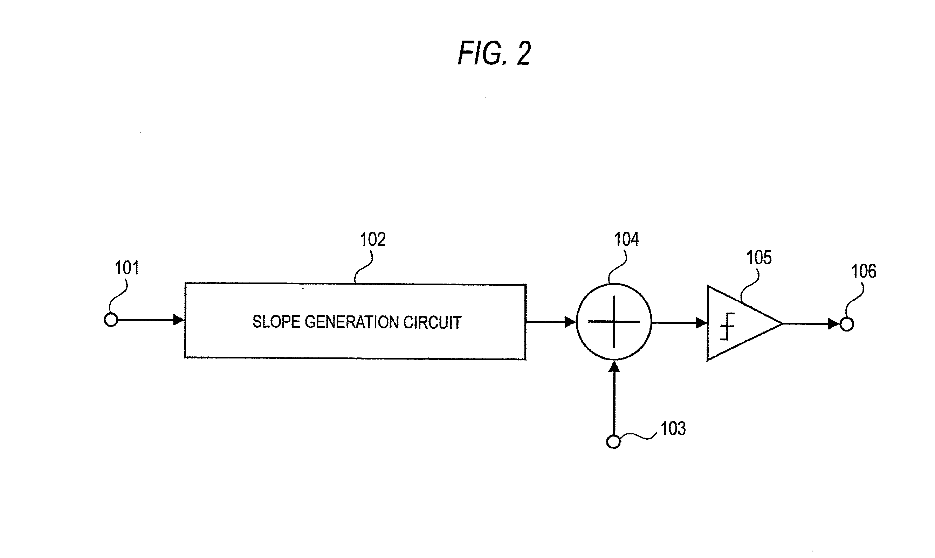

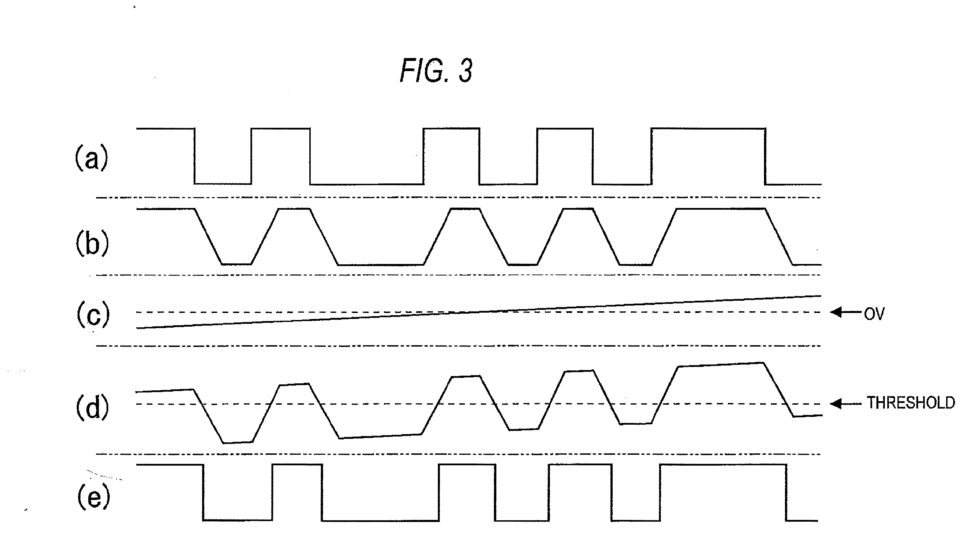

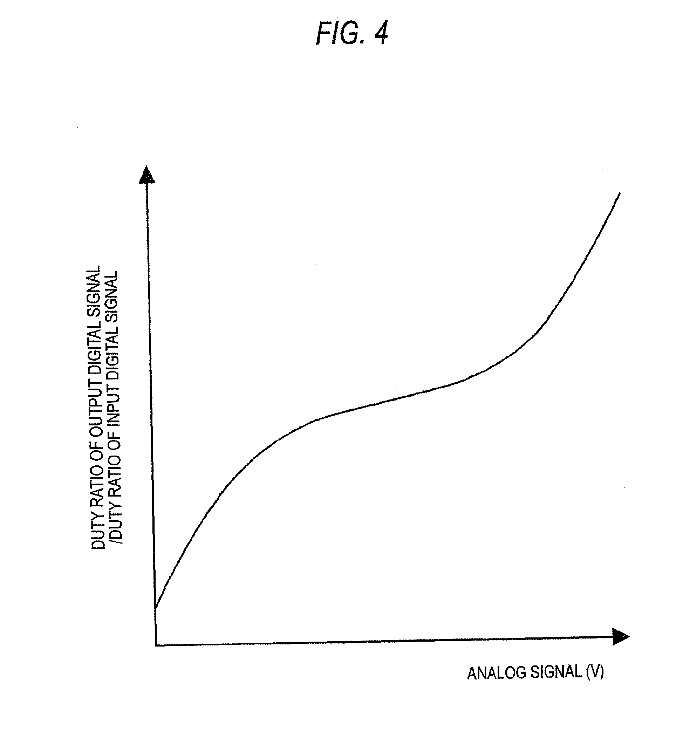

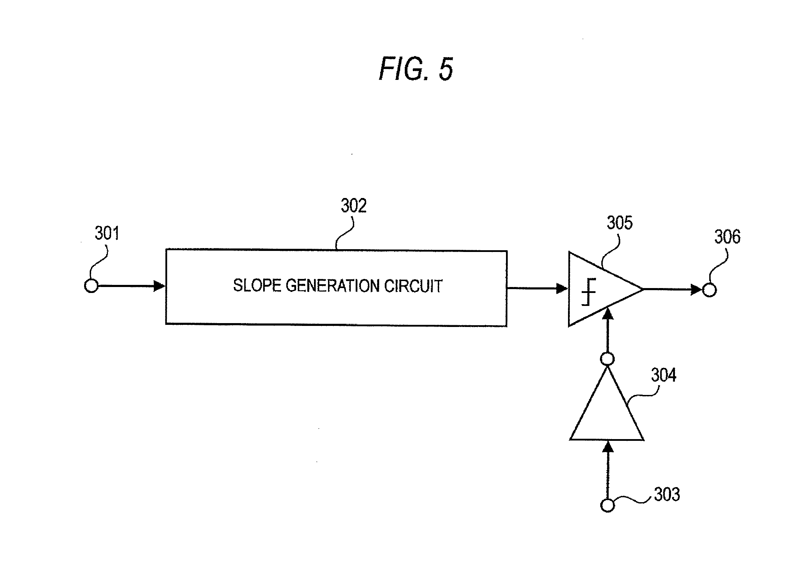

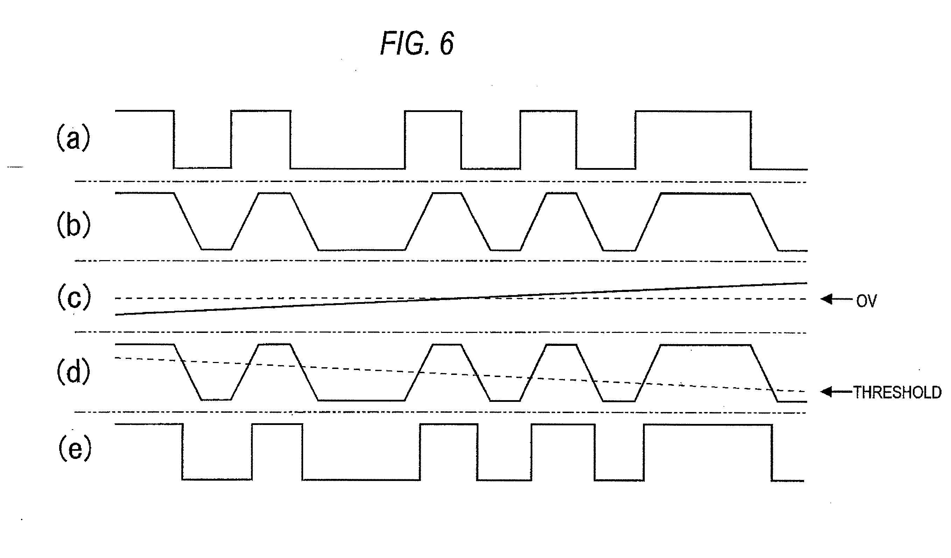

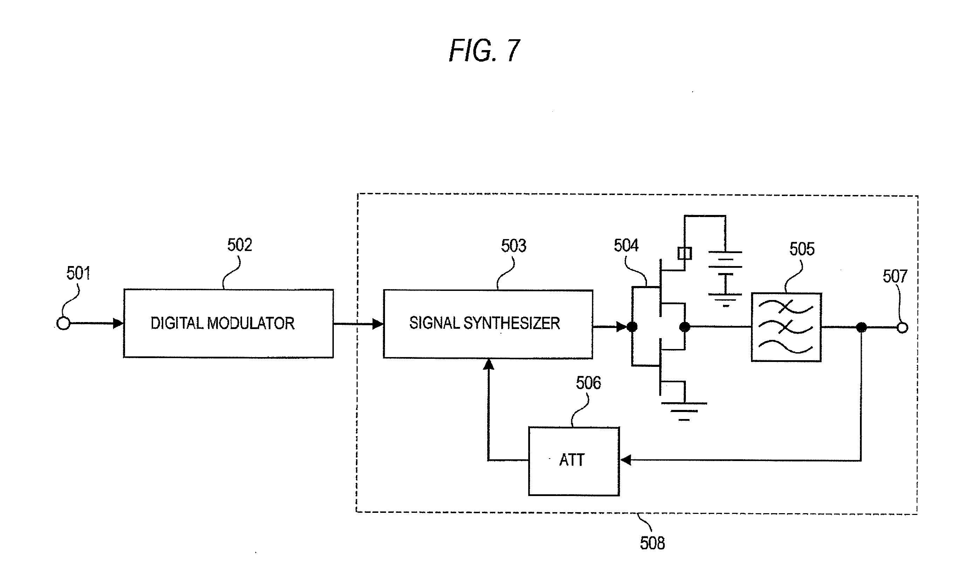

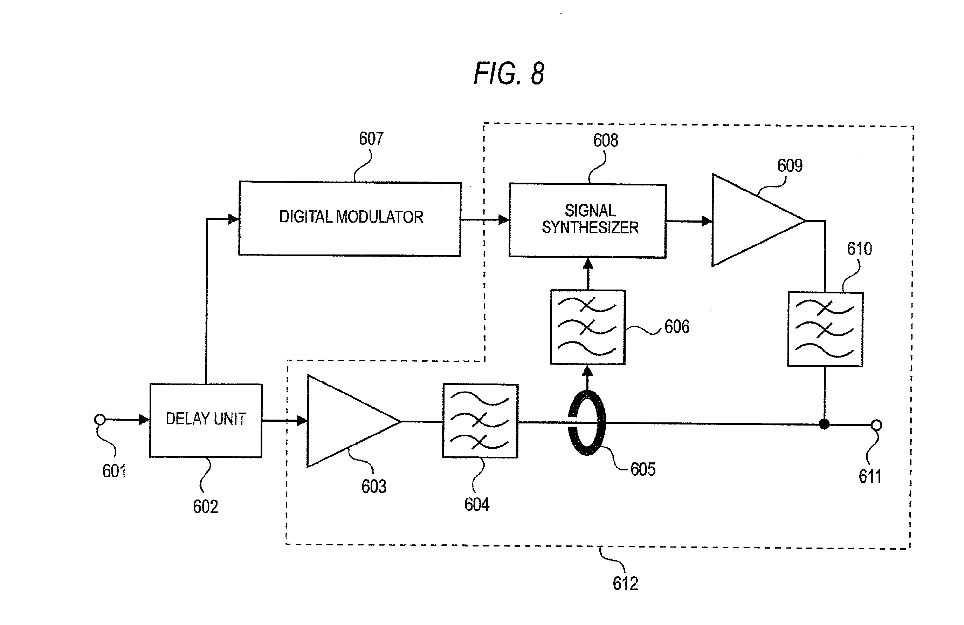

{Fig. 1} A figure is a block diagram illustrating a configuration of a digital audio amplifier of the related art.
{Fig. 2} A figure is a block diagram illustrating a configuration of a signal synthesis circuit that is a first embodiment of the present invention.
{Fig. 3} A figure is a timing chart illustrating output signals of various units in the first embodiment of the present invention.
{Fig. 4} A figure is a characteristic diagram illustrating relations among a signal output from a 1-bit digital signal output terminal, a signal input from a 1-bit digital signal input terminal, and a signal input from an analog signal input terminal.
{Fig. 5} A figure is a block diagram illustrating a configuration of a signal synthesis circuit that is a second embodiment of the present invention.
{Fig. 6} A figure is a timing chart illustrating output signals of various units in the second embodiment of the present invention.
{Fig. 7} A figure is a block diagram illustrating a configuration of a digital audio amplifier that is a third embodiment of the present invention.
{Fig. 8} A figure is a block diagram illustrating a configuration of a power supply circuit that is a fourth embodiment of the present invention.

### {Description of Embodiments}

Hereafter, exemplary embodiments according to the present invention will be described in detail with reference to the drawings.

### (First embodiment)

Fig. 2 is a block diagram of a signal synthesis circuit that is a first embodiment of the present invention. The signal synthesis circuit illustrated in Fig. 2 becomes an addition circuit or a subtraction circuit. The signal synthesis circuit includes a 1-bit digital signal input terminal 101, a slope generation circuit 102, an analog signal input terminal 103, an analog adder 104, a comparator 105, and a 1-bit digital signal output terminal 106. The analog adder 104 and the comparator 105 constitute a 1-bit decision circuit.

A 1-bit digital signal is input to the 1-bit digital signal input terminal 101. The slope generation circuit 102 imposes slew rate restrictions on a signal waveform of the digital signal input from the 1-bit digital signal input terminal 101, thereby prolongs a time period during which the 1-bit signal makes a transition between a high state and a low state, and inclines the signal waveform. An analog signal is input to the analog signal input terminal 103. The analog adder 104 performs analog addition on an output signal of the slope generation circuit 102 and the analog signal input from the analog signal input 103, and outputs a resultant signal to the comparator 105. The comparator 105 compares the output signal of the analog adder 104 with a preset threshold voltage. When a voltage of the output signal is higher than the threshold voltage, the comparator 105 outputs a "high" level. Conversely, when the voltage of the output signal is lower than the threshold voltage, the comparator 105 outputs a "low" level. The 1-bit digital signal output terminal 106 outputs the output signal of the comparator 105 to the outside as a 1-bit signal.

In the signal synthesis circuit in the present embodiment, the signal input from the 1-bit digital signal input 101 is a 1-bit digital signal in PWM (Pulse Width Modulation), PDM (Pulse Density Modulation), PFM (Pulse Frequency Modulation) or the like. Each of these 1-bit digital signals represents magnitude of the output signal by a length of a time period over which the output signal becomes high. A ratio of a time period over which the output signal is high, to a unit time period is called duty ratio.

In Fig. 3, (a) is a timing chart illustrating a waveform of the input signal at the 1-bit digital signal input terminal 101. In Fig. 3, (b) is a timing chart illustrating a waveform of the output signal of the slope generation circuit 102. In Fig. 3, (c) is a timing chart illustrating a waveform of the input signal at the analog signal input 103. In Fig. 3, (d) is a timing chart illustrating a waveform of the output signal of the analog adder 104. In Fig. 3, (e) is a timing chart illustrating a waveform of the output signal of the comparator 105.

Viewing (a) to (e) in Fig. 3, it is appreciated that time periods over which the output signal ((e) in Fig. 3) of the comparator 105 is high, change from those in the input signal ((a) in Fig. 3) at the 1-bit digital signal input 101. As the value of the input signal ((c) in Fig. 3) at the analog signal input 103 becomes smaller, the time period over which the output signal ((e) in Fig. 3) of the comparator 105 is high becomes shorter (i.e., the duty ratio becomes smaller). This means that the signal output from the 1-bit digital signal output terminal 106 exhibits a smaller value as compared with the signal input from the 1-bit digital signal input terminal 101. Conversely, as the value of the input signal ((c) in Fig. 3) at the analog signal input 103 becomes larger, the time period over which the output signal ((e) in Fig. 3) of the comparator 105 is high becomes longer (i.e., the duty ratio becomes larger). This means that the signal output from the 1-bit digital signal output terminal 106 exhibits a larger value as compared with the signal input from the 1-bit digital signal input terminal 101.

Owing to the configuration described heretofore, it is possible to obtain a signal synthesis circuit that performs addition between an analog signal and a 1-bit digital signal without using an analog-digital converter or a digital-analog converter.

Here, inclination of the output signal of the slope generation circuit 102 during a transition time period may not be a constant value. In this case, the signal output from the 1-bit digital signal output terminal 106 does not become a simple sum of the signal input from the 1-bit digital signal input terminal 101 and the signal input from the analog signal input terminal 103. If the signal input from the 1-bit digital signal input terminal 101 has a slope of positive inclination for a time period of transition from low to high and the signal input from the 1-bit digital signal input terminal 101 has a slope of negative inclination for a time period of transition from high to low, however, an operation equivalent to multiplying the signal ((c) in Fig. 3) input from the analog signal input terminal 103 by an arbitrary function and adding a resultant signal to the signal ((a) in Fig. 3) input from the 1-bit digital signal input terminal 101 is conducted. As a simple circuit configuration for obtaining such characteristics, a configuration obtained by replacing the slope generation circuit by a low-pass filter is conceivable.

In the signal synthesis circuit illustrated in Fig. 2, it is desirable that the slope (inclination) generated by the slope generation circuit 102 is larger than a maximum slope (inclination) of the signal input from the analog signal input terminal 103. Furthermore, it is desirable that maximum amplitude of the signal input from the analog signal input terminal 103 is smaller than amplitude of the signal output from the slope generation circuit 102. By doing so, it is possible to keep the signal output from the 1-bit digital signal output terminal 106 in signal frequency nearly equal to the signal input from the 1-bit analog signal input 101.

Furthermore, in a case where the output signal voltage of the slope generation circuit 102 is Vhigh volt at its maximum and Vlow volt at its minimum, the threshold voltage of the comparator 105 is prescribed arbitrarily between Vhigh and Vlow. It is desirable that the threshold voltage of the comparator 105 is a center value of the output signal of the slope generation circuit 102. In other words, in a case where the output signal voltage of the slope generation circuit 102 is Vhigh volt at its maximum and Vlow volt at its minimum, it is desirable that the threshold voltage of the comparator 105 is (Vhigh + Vlow)/2.

Relations among the signal output from the 1-bit digital signal output terminal 106, the signal input from the 1-bit digital signal input terminal 101, and the signal input from the analog signal input terminal 103 in the circuit in the first embodiment are illustrated in Fig. 4. Relations between a value obtained by dividing a duty ratio of the signal output from the 1-bit digital signal output terminal 106 by a duty ratio of the signal input from the 1-bit digital signal input terminal 101 and the value of the signal input from the analog signal input terminal 103 can be plotted as a segment of a line always having positive inclination. However, a shape of the segment in Fig. 4 illustrates an example. The function may be a first order function or may be a high order function as long as the segment always has positive inclination.

### (Second embodiment)

Fig. 5 is a block diagram of a signal synthesis circuit that is a second embodiment of the present invention. The signal synthesis circuit illustrated in Fig. 5 becomes an addition circuit or a subtraction circuit. The signal synthesis circuit includes a 1-bit digital signal input terminal 301, a slope generation circuit 302, an analog signal input terminal 303, an analog inversion amplifier 304, a comparator 305, and a 1-bit digital signal output terminal 306. The analog inversion amplifier 304 and the comparator 305 constitute a 1-bit decision circuit.

A 1-bit digital signal is input to the 1-bit digital signal input terminal 301. The slope generation circuit 302 imposes slew rate restrictions on a signal waveform of the digital signal input from the 1-bit digital signal input terminal 301, thereby prolongs a time period during which the 1-bit signal makes a transition between a high state and a low state, and inclines the signal waveform. An analog signal to be added in the present circuit is input to the analog signal input terminal 303. The analog inversion amplifier 304 multiplies the analog signal input from the analog signal input terminal 303 by a negative coefficient and outputs a resultant signal. An output signal of the slope generation circuit 302 is input to the comparator 305 as an input signal. An output signal of the analog inversion amplifier 304 is input to the comparator 305 as a threshold voltage. And when a voltage of the input signal is higher than the threshold voltage, the comparator 305 outputs a "high" level. Conversely, when the voltage of the input signal is lower than the threshold voltage, the comparator 305 outputs a "low" level. The 1-bit digital signal output terminal 306 outputs the output signal of the comparator 305 to the outside as a 1-bit signal.

In the signal synthesis circuit in the present embodiment, the signal input from the 1-bit digital signal input 301 is a 1-bit digital signal in PWM (Pulse Width Modulation), PDM (Pulse Density Modulation), PFM (Pulse Frequency Modulation) or the like. Each of these 1-bit digital signals represents magnitude of the output signal by a length of a time period over which the output signal becomes high. A ratio of a time period over which the output signal is high, to a unit time period is called duty ratio.

In the signal synthesis circuit illustrated in Fig. 5, addition of the analog signal and the 1-bit digital signal is performed by causing a transition in the threshold voltage of the comparator 305 on the basis of the input signal from the analog signal input terminal 303. If characteristics of the slope generation circuit 302 are made the same as characteristics of the slope generation circuit 102, a computation result obtained in the signal synthesis circuit illustrated in Fig. 5 becomes the same as the computation result obtained in the signal synthesis circuit illustrated in Fig. 2. In Fig. 6, (a) is a timing chart illustrating a waveform of the input signal at the 1-bit digital signal input terminal 301. In Fig. 6, (b) is a timing chart illustrating a waveform of the output signal of the slope generation circuit 302. In Fig. 6, (c) is a timing chart illustrating a waveform of the input signal at the analog signal input terminal 303. In Fig. 6, (d) is a timing chart illustrating waveforms of relations between the input signal of the comparator 305 and the threshold voltage. In Fig. 6, (e) is a timing chart illustrating a waveform of the output signal of the comparator 305.

Owing to the configuration described heretofore, it is possible to obtain a signal synthesis circuit that performs addition between an analog signal and a 1-bit digital signal without using an analog-digital converter or a digital-analog converter.

Here, inclination of the output signal of the slope generation circuit 302 during a transition time period may not be a constant value. In this case, the signal output from the 1-bit digital signal output terminal 306 does not become a simple sum of the signal input from the 1-bit digital signal input terminal 301 and the signal input from the analog signal input terminal 303. If the signal input from the 1-bit digital signal input terminal 301 has a slope of positive inclination for a time period of transition from low to high and the signal input from the 1-bit digital signal input terminal 301 has a slope of negative inclination for a time period of transition from high to low, however, an operation equivalent to multiplying the signal ((c) in Fig. 6) input from the analog signal input terminal 303 by an arbitrary function and adding a resultant signal to the signal ((a) in Fig. 6) input from the 1-bit digital signal input terminal 301 is conducted. As a simple circuit configuration for obtaining such characteristics, a configuration obtained by replacing the slope generation circuit 302 by a low-pass filter is conceivable.

In the signal synthesis circuit illustrated in Fig. 5, it is desirable that inclination of the slope generated by the slope generation circuit 302 is larger than a maximum inclination of the signal input from the analog signal input terminal 303. Furthermore, it is desirable that maximum amplitude of the signal input from the analog signal input terminal 303 is smaller than amplitude of the signal output from the slope generation circuit. By doing so, it is possible to keep the signal output from the 1-bit digital signal output terminal 306 in signal frequency nearly equal to the signal input from the 1-bit analog signal input 301.

Relations among the signal output from the 1-bit digital signal output terminal 306, the signal input from the 1-bit digital signal input terminal 301, and the signal input from the analog signal input terminal 303 in the circuit in the second embodiment are illustrated in Fig. 4. Relations between a value obtained by dividing a duty ratio of the signal output from the 1-bit digital signal output terminal 306 by a duty ratio of the signal input from the 1-bit digital signal input terminal 301 and the value of the signal input from the analog signal input terminal 103 can be plotted as a segment of a line always having positive inclination. However, a shape of the segment in Fig. 4 illustrates an example. The function may be a first order function or may be a high order function as long as the segment always has positive inclination.

### (Third embodiment)

Fig. 7 is a block diagram of a digital audio amplifier that is a third embodiment of the present invention. The digital audio amplifier illustrated in Fig. 7 includes a signal input terminal 501, a digital modulator 502, a signal synthesizer 503, a D-class amplifier 504, a low-pass filter 505, an attenuator 506, and an analog signal output terminal 507.

As for the signal synthesizer 503 in the digital audio amplifier in the present embodiment, the signal synthesis circuit in the first embodiment illustrated in Fig. 2 or the signal synthesis circuit in the second embodiment illustrated in Fig. 5 is used.

The signal input terminal 501 receives a signal from the outside. The digital modulator 502 converts the signal input from the signal input terminal 501 to a 1-bit pulse pattern, and outputs the 1-bit pulse pattern to the signal synthesizer 503. The signal synthesizer 503 combines the output signal of the digital modulator 502 and an output signal of the attenuator 506, and outputs a resultant synthesized signal to the D-class amplifier 504. The D-class amplifier 504 amplifies the output signal of the signal synthesizer 503, and outputs a resultant signal to the low-pass filter 505. The low-pass filter 505 removes high frequency noise components from the output signal of the D-class amplifier 504, and outputs a resultant signal to the attenuator 506 and the analog signal output terminal 507. The attenuator 506 attenuates the output signal of the low-pass filter 505 with a preset ratio, and outputs a resultant signal to the signal synthesizer 503. This ratio is set according to a gain of a power amplification circuit block 508. The analog signal output terminal 507 outputs the output signal of the low-pass filter 505 to the outside.

In a case where the signal synthesis circuit illustrated in Fig. 2 is used as the signal synthesizer 503, the output signal of the digital modulator 502 is input to the 1-bit digital signal input terminal 101. Furthermore, the output signal of the attenuator 506 is input to the analog signal input terminal 103, and the output signal from the 1-bit digital signal output terminal 106 is input to the D-class amplifier 504. On the other hand, in a case where the signal synthesis circuit illustrated in Fig. 5 is used as the signal synthesizer 503, the output signal of the digital modulator 502 is input to the 1-bit digital signal input terminal 301. Furthermore, the output signal of the attenuator 506 is input to the analog signal input terminal 303, and the output signal from the 1-bit digital signal output terminal 306 is input to the D-class amplifier 504.

Furthermore, in the third embodiment illustrated in Fig. 7, the digital modulator 502 is a 1-bit digital modulator such as a PWM (Pulse Width Modulation) modulator or a delta sigma modulator, and the digital modulator 502 outputs a 1-bit digital signal.

Furthermore, in the third embodiment illustrated in Fig. 7, it is possible to prepare a plurality of power amplification circuit blocks 508 each including the signal synthesizer 503, the D-class amplifier 504, the low-pass filter 505, the attenuator 506 and the analog signal output terminal 507 and arrange the power amplification circuit blocks 508 in parallel. In this case, a 1-bit digital signal output from one digital modulator 502 is input to all of the power amplification circuit blocks 508 arranged plurally, and output signals are output respectively from all of the power amplification circuit blocks 508 arranged plurally. Therefore, it becomes possible to obtain a plurality of outputs without increasing the number of the digital modulators 502.

### (Fourth embodiment)

Fig. 8 is a block diagram of a power supply circuit that is a fourth embodiment of the present invention. The power supply circuit illustrated in Fig. 8 includes a signal input terminal 601, a delay unit 602, a linear amplifier 603, a high-pass filter 604, a current detector 605, a low-pass filter 606, a digital modulator 607, a signal synthesizer 608, a switching amplifier 609, a low-pass filter 610, and an analog signal output terminal 611.

As for the signal synthesizer 608 in the power supply circuit in the present embodiment, the signal synthesis circuit in the first embodiment illustrated in Fig. 2 or the signal synthesis circuit in the second embodiment illustrated in Fig. 5 is used.

The signal input terminal 601 receives a signal to be amplified by the power supply circuit in the present embodiment. The delay unit 602 distributes the signal input from the signal input terminal 601 to the linear amplifier 603 and the digital modulator 607. At this time, a signal supplied to the linear amplifier 603 is provided with a time delay as compared with a signal supplied to the digital modulator 607. A value of this time delay is set to cause no time difference between a first route passed through by a signal since the signal is input to the digital modulator 607 until the signal is output from the low-pass filter 610 and a second route passed through by a signal since the signal is input to the linear amplifier 603 until the signal is output from the current detector 605. It is also possible to input the signal input from the signal input terminal 601 as it is, directly to the digital modulator 607 and provide only a signal input to the linear amplifier 603 with a time delay in the delay unit 602. The linear amplifier 603 amplifies a signal supplied from the delay unit 602, and outputs a resultant signal to the high-pass filter 604. The high-pass filter 604 removes low frequency components from the output signal of the linear amplifier 603, and outputs a resultant signal to the current detector 605. The current detector 605 outputs the output signal of the high-pass filter 604 to the analog signal output terminal 611. In addition, the current detector 605 detects a current value of the output signal of the high-pass filter 604, and outputs the current value to the low-pass filter 606. The low-pass filter 606 detects an output signal of the current detector 605, removes high frequency components, and outputs a resultant signal to the signal synthesizer 608.

The digital modulator 607 converts the signal supplied from the delay unit 602 to a 1-bit digital signal in PWM or the like, and outputs the 1-bit digital signal to the signal synthesizer 608. The signal synthesizer 608 combines the output signal of the digital modulator 607 and the output signal of the low-pass filter 604, and outputs a resultant synthesized signal to the switching amplifier 609. The switching amplifier 609 amplifies the output signal of the signal synthesizer 608, and outputs a resultant signal to the low-pass filter 610. The low-pass filter 610 removes high frequency noise from the output signal of the switching amplifier 609, and outputs a resultant signal to the analog signal output terminal 611. The output signal of the high-pass filter 604 and the output terminal of the low-pass filter 610 are coupled to the same node, and the two output signals are subjected to current synthesis and a resultant signal is output from the analog signal output terminal 611.

In a case where the signal synthesis circuit illustrated in Fig. 2 is used as the signal synthesizer 608, the output signal of the digital modulator 607 is input to the 1-bit digital signal input terminal 101. Furthermore, the output signal of the low-pass filter 606 is input to the analog signal input terminal 103, and the output signal from the 1-bit digital signal output terminal 106 is input to the switching amplifier 609. On the other hand, in a case where the signal synthesis circuit illustrated in Fig. 5 is used as the signal synthesizer 608, the output signal of the digital modulator 607 is input to the 1-bit digital signal input terminal 301. Furthermore, the output signal of the low-pass filter 606 is input to the analog signal input terminal 303, and the output signal from the 1-bit digital signal output terminal 306 is input to the switching amplifier 609.

Furthermore, in the power supply circuit illustrated in Fig. 8, a cutoff frequency of the high-pass filter 604 is set to a frequency lower than a cutoff frequency of the low-pass filter 610.

Furthermore, in the third embodiment illustrated in Fig. 8, it is possible to prepare a plurality of power amplification circuit blocks 612 each including the linear amplifier 603, the high-pass filter 604, the current detector 605, the low-pass filter 606, the signal synthesizer 608, the switching amplifier 609, the low-pass filter 610 and the analog signal output terminal 611 and arrange the power amplification circuit blocks 612 in parallel. A signal output from one delay unit 602 and a 1-bit digital signal output from one digital modulator 607 are input to all of the power amplification circuit blocks 612 arranged plurally, and output signals are output respectively from all of the power amplification circuit blocks 612 arranged plurally. Therefore, it becomes possible to obtain a plurality of outputs without increasing the number of the delay units 602 and the digital modulators 607.

In the above described first and second embodiments, the slope generation circuit generates a slope in the first 1-bit digital signal during a time period of transition of the first 1-bit digital signal from a high level to a low level and a time period of transition of the first 1-bit digital signal from a low level to a high level. However, the slope generation circuit may generate a slope in the first 1-bit digital signal during either a time period of transition of the first 1-bit digital signal from a high level to a low level or a time period of transition of the first 1-bit digital signal from a low level to a high level.

Furthermore, the analog signal in (c) in Fig. 3 and (c) in Fig. 6 is illustrated to increase monotonously. However, this is illustrated for simplifying the description. For example, a signal that increases and decreases in signal level such as a sine wave is also included.

The above-described embodiments are preferable embodiments of the present invention. However, the scope of the present invention is not restricted only to the above-described embodiments. Execution in forms subjected to various changes is possible without departing from the subject-matter of the present invention. Therefore, the above-described embodiments are nothing but simple illustration, and the present invention should not be interpreted restrictively. The scope of the present invention is indicated by claims, and not constrained by statements in the description and abstract. In addition, all modifications and changes belonging to an equivalent scope of claims are within the scope of the present invention.

The present application claims priority based on Japanese Patent Application No. 2011-209379 filed on September 26, 2011. All contents disclosed in Japanese Patent Application No. 2011-209379 are incorporated in contents of the present application.

A part or all of the above-described embodiments can be stated as in the ensuing additions as well, but it is not restricted to the configurations described hereafter.

### (Supplementary note 1)

A signal synthesis circuit comprising:
a slope generation circuit that receives a first 1-bit digital signal as an input, generates a slope on the first 1-bit digital signal during at least one of a time period of transition of the first 1-bit digital signal from high to low and a time period of transition of the first 1-bit digital signal from low to high, and outputs a resultant signal; and
a 1-bit decision circuit that receives an analog signal and an output signal of the slope generation circuit as inputs, varies a high-low decision on the output signal of the slope generation circuit by using the analog signal, and outputs a second 1-bit digital signal generated by the high-low decision,
a duty ratio of the first 1-bit digital signal being varied based on the analog signal and the second 1-bit digital signal being output.

(Supplementary note 2)

The signal synthesis circuit according to Supplementary note 1, wherein the 1-bit decision circuit receives the analog signal and the output signal of the slope generation circuit as inputs, causes at least one of the output signal and a threshold to vary by using the analog signal, performs a high-low decision by comparing the output signal and the threshold, at least one of which varies, with each other, and outputs a second 1-bit digital signal generated by the high-low decision.

### (Supplementary note 3)

The signal synthesis circuit according to Supplementary note 1 or 2, wherein the slope generation circuit includes a low-pass filter.

### (Supplementary note 4)

The signal synthesis circuit according to any one of Supplementary notes 1 to 3, wherein the slope added to the output signal of the slope generation circuit is larger than a maximum slope of the analog signal.

### (Supplementary note 5)

The signal synthesis circuit according to any one of Supplementary notes 1 to 4, wherein amplitude of the output signal of the slope generation circuit is larger than maximum amplitude of the analog signal.

### (Supplementary note 6)

The signal synthesis circuit according to any one of Supplementary notes 1 to 5, wherein the 1-bit decision circuit includes:
an analog adder that performs addition of the output signal of the slope generation circuit and the analog signal; and
a comparator that compares the output signal of the analog adder with a threshold voltage, outputs a high signal when a voltage of the output signal is higher than the threshold voltage, and outputs a low signal when the voltage of the output signal is lower than the threshold voltage.

### (Supplementary note 7)

The signal synthesis circuit according to any one of Supplementary notes 1 to 5, wherein the 1-bit decision circuit includes:
an analog inversion amplifier that inverts a positive-negative polarity of the analog signal and outputs a resultant signal; and
a comparator that receives the output signal of the slope generation circuit and the output signal of the analog inversion amplifier as inputs, outputs a high signal when a voltage of the output signal of the slope generation circuit is higher than a voltage of the output signal of the analog inversion amplifier, and outputs a low signal when the voltage of the output signal of the slope generation circuit is lower than the voltage of the output signal of the analog inversion amplifier.

### (Supplementary note 8)

A digital audio amplifier comprising:
a digital modulator that converts an input signal to a third 1-bit digital signal; and
a power amplification circuit block that amplifies an output signal of the digital converter, wherein
the power amplification circuit block includes:
   an attenuator;
   a signal synthesizer that combines the third 1-bit digital signal with an output signal of the attenuator and outputs a resultant synthesized signal;
   a D-class amplifier that amplifies an output signal of the signal synthesizer; and
   a low-pass filter that removes high frequency noise components from an output signal of the D-class amplifier and outputs a resultant signal,
   the attenuator detecting an output signal of the low-pass filter, attenuating the output signal with a preset ratio, and outputting a resultant signal to the signal synthesizer, the signal synthesizer being a signal synthesis circuit according to any one of Supplementary notes 1 to 7,
   the third 1-bit digital signal being input as the first 1-bit digital signal, and an output signal of the attenuator being input as the analog signal.

### (Supplementary note 9)

The digital audio amplifier according to Supplementary note 8, wherein a plurality of the power amplification circuit blocks are mounted in parallel, and the output signal of the digital converter is input to the plurality of power amplification circuit blocks, and each of the plurality of power amplification circuit blocks amplifies the output signal of the digital converter and outputs a resultant signal.

### (Supplementary note 10)

A power supply circuit comprising:
a digital modulator that receives a first distributed signal obtained by separating an input signal as an input and converts the first distributed signal to a third 1-bit digital signal;
a power amplification circuit block that receives a signal obtained by delaying a second distributed signal obtained by separating the input signal and the third 1-bit digital signal as inputs, amplifies the second distributed signal and the third 1-bit digital signal, then performs power synthesis, and outputs a resultant signal; and
a delay unit that provides the second distributed signal with a time delay as compared with the first distributed signal and outputs a resultant signal to the power amplification circuit block as the signal,
the power amplification circuit block including:
   a linear amplifier that receives the delayed second distributed signal as an input, amplifies the delayed second distributed signal, and outputs a resultant signal;
   a high-pass filter that receives an output signal of the linear amplifier as an input, removes low frequency components, and outputs a resultant signal;
   a current detector that detects a current component from an output signal of the high-pass filter, and outputs the current components;
   a first low-pass filter that receives an output signal of the current detector, removes high frequency components, and outputs a resultant signal;
   a signal synthesizer that receives the third 1-bit digital signal and an output signal of the first low-pass filter as inputs, combines them, and outputs a resultant synthesized signal;
   a switching amplifier that amplifies the output signal of the signal synthesizer; and
   a second low-pass filter that removes high frequency noise components from an output signal of the switching amplifier, and outputs a resultant signal,
   the signal synthesizer being the signal synthesis circuit according to any one of Supplementary notes 1 to 7,
   the third 1-bit digital signal being input as the first 1-bit digital signal,
   an output signal of the first low-pass filter being input as the analog signal,
   a cutoff frequency of the high-pass filter being lower in frequency than a cutoff frequency of the second low-pass filter, and
   an output signal of the second low-pass filter and the output signal of the high-pass filter being subject to power synthesis and a resultant signal being output.

### (Supplementary note 11)

The power circuit according to Supplementary note 10, wherein
a plurality of the power amplification circuit blocks are mounted in parallel, the third 1-bit digital signal and the delayed second distributed signal are input to the plurality of power amplification circuit blocks, and
each of the plurality of the power amplification circuit blocks amplifies the third 1-bit digital signal and the delayed second distributed signal and performs power synthesis.

### (Supplementary note 12)

A signal synthesis method in a signal synthesis circuit, the signal synthesis method including:
a first step of generating a slope on an input first 1-bit digital signal during at least one of a time period of transition of the first 1-bit digital signal from high to low and a time period of transition of the first 1-bit digital signal from low to high; and
a second step of causing a high-low decision on the first 1-bit digital signal with the generated slope to vary by using an input analog signal, and outputting a second 1-bit digital signal generated by the high-low decision,
the second 1-bit digital signal being a signal obtained by varying a duty ratio of the first 1-bit digital signal on the basis of the analog signal.

### (Supplementary note 13)

The signal synthesis method according to Supplementary note 12, wherein the second step includes causing at least one of the first 1-bit digital signal with the slope generated and a threshold to vary by using the input analog signal, performing a high-low decision by comparing the output signal and the threshold, at least one of which varies, with each other, and outputs the second 1-bit digital signal generated by the high-low decision.

### (Supplementary note 14)

The signal synthesis method according to Supplementary note 12 or 13, wherein at the first step, the slope is generated by using a low-pass filter.

### (Supplementary note 15)

The signal synthesis method according to any of Supplementary notes 12 to 14, wherein the slope is larger than a maximum slope of the analog signal.

### (Supplementary note 16)

The signal synthesis method according to any of Supplementary notes 12 to 15, wherein amplitude of the first 1-bit digital signal with the slope generated is larger than maximum amplitude of the analog signal.

### (Supplementary note 17)

The signal synthesis method according to any of Supplementary notes 12 to 16, wherein the second step includes:
a step of performing addition of the first 1-bit digital signal with the slope generated and the analog signal; and
a step of outputting a high signal when a voltage of a signal after the addition is higher than a threshold voltage and outputting a low signal when the voltage of the signal after the addition is lower than the threshold voltage.

### (Supplementary note 18)

The signal synthesis method according to any of Supplementary notes 12 to 16, wherein the second step includes:
a step of inverting a positive-negative polarity of the analog signal; and
a step of comparing a voltage of the first 1-bit digital signal with the slope generated with a voltage of the analog signal inverted in positive-negative polarity, outputting a high signal when the voltage of the first 1-bit digital signal with the slope generated is higher than the voltage of the analog signal inverted in positive-negative polarity, and outputting a low signal when the voltage of the first 1-bit digital signal with the slope generated is lower than the voltage of the analog signal inverted in positive-negative polarity.

### (Supplementary note 19)

A method of driving a digital audio amplifier, including:
a conversion step of converting an input signal to a third 1-bit digital signal; and
a power amplification step of amplifying the third 1-bit digital signal,
the power amplification step including:
   a synthesis step of combining the third 1-bit digital signal with an input analog signal;
   an amplification step of amplifying a signal obtained by the synthesis;
   a removal step of removing high frequency noise components from the amplified signal; and
   a step of detecting the signal from which high frequency noise components are removed, attenuating the signal with a preset ratio, and outputting a resultant signal as the analog signal in the synthesis step,
   the synthesis step being conducted by using a signal synthesis method according to any of Supplementary notes 12 to 18,
   the third 1-bit digital signal being input as the first 1-bit digital signal, and the analog signal in the synthesis step being input as the analog signal in the signal synthesis method according to any of Supplementary notes 12 to 18.

### (Supplementary note 20)

The method according to Supplementary note 19, wherein a plurality of the power amplification steps are conducted in parallel on the third 1-bit digital signal generated in the conversion step.

### (Supplementary note 21)

A method of driving a power supply circuit, including:
a conversion step of converting a first distributed signal obtained by separating an input signal to a third 1-bit digital signal;
a step of providing a second distributed signal obtained by separating the input signal with a time delay as compared with the first distributed signal; and
a power amplification circuit step of amplifying the delayed second distributed signal and the third 1-bit digital signal respectively, then performing power synthesis, and outputting a resultant signal,
the power amplification circuit step including:
   a step of amplifying the delayed second distributed signal and outputting a resultant signal;
   a step of removing low frequency components of the amplified signal and outputting a resultant signal;
   a step of detecting a current component from the signal from which the low frequency components are removed and outputting a resultant signal;
   a first removal step of removing high frequency components of the signal after the current component detection;
   a signal synthesis step of combining the third 1-bit digital signal with the signal from which high frequency components are removed and outputting a resultant signal;
   a step of amplifying the signal after the synthesis; and
   a second removal step of removing high frequency noise components from the amplified signal,
   the signal synthesis step being conducted by using the signal synthesis method according to any one of Supplementary notes 12 to 18,
   the third 1-bit digital signal being input as the first 1-bit digital signal,
   the signal with the high frequency components removed in the first removal step being input as the analog signal,
   a cutoff frequency in the step of removing low frequency components and outputting a resultant signal being lower in frequency than a cutoff frequency in the second removal step, and
   the output signal in the second removal step and the output signal in the step of removing the low frequency components and outputting a resultant signal being subject to power synthesis and a resultant signal being output.

### (Supplementary note 22)

The method according to Supplementary note 21, wherein a plurality of the power amplification steps are conducted in parallel on the third 1-bit digital signal generated in the conversion step.

### {Industrial Applicability}

The present invention can be applied to a circuit that performs addition or subtraction between an analog signal and a 1-bit digital signal, and can be applied to an analog-digital mixture circuit such as a digital audio amplifier and a power supply circuit.

### {Reference Sings List}

- 101, 301: 1-bit digital signal input terminal
- 102, 302: Slope generation circuit
- 103, 303: Analog signal input terminal
- 104: Analog adder
- 105, 305: Comparator
- 106, 306: 1-bit digital signal output terminal
- 304: Analog inversion amplifier
- 501, 601: Signal input
- 502, 607: Digital modulator
- 503, 608: Signal synthesizer
- 504: D-class amplifier
- 505, 606, 610: Low-pass filter
- 506: Attenuator
- 507, 611: Analog signal output
- 508, 612: Power amplification circuit block
- 602: Delay unit
- 603: Linear amplifier
- 604: High-pass filter
- 605: Current detector
- 609: Switching amplifier

## Claims

1. A signal synthesis circuit comprising:
a slope generation circuit that receives a first 1-bit digital signal as an input, generates a slope on the first 1-bit digital signal during at least one of a time period of transition of the first 1-bit digital signal from high to low and a time period of transition of the first 1-bit digital signal from low to high, and outputs a resultant signal; and
a 1-bit decision circuit that receives an analog signal and an output signal of the slope generation circuit as inputs, varies a high-low decision on the output signal of the slope generation circuit by using the analog signal, and outputs a second 1-bit digital signal generated by the high-low decision,
a duty ratio of the first 1-bit digital signal being varied based on the analog signal and the second 1-bit digital signal being output.

2. The signal synthesis circuit according to claim 1, wherein the slope generation circuit includes a low-pass filter.

3. The signal synthesis circuit according to claim 1 or 2, wherein the slope added to the output signal of the slope generation circuit is larger than a maximum slope of the analog signal.

4. The signal synthesis circuit according to any one of claims 1 to 3, wherein amplitude of the output signal of the slope generation circuit is larger than maximum amplitude of the analog signal.

5. The signal synthesis circuit according to any one of claims 1 to 4, wherein the 1-bit decision circuit includes:
an analog adder that performs addition of the output signal of the slope generation circuit and the analog signal; and
a comparator that compares the output signal of the analog adder with a threshold voltage, outputs a high signal when a voltage of the output signal is higher than the threshold voltage, and outputs a low signal when the voltage of the output signal is lower than the threshold voltage.

6. The signal synthesis circuit according to any one of claims 1 to 4, wherein the 1-bit decision circuit includes:
an analog inversion amplifier that inverts a positive-negative polarity of the analog signal and outputs a resultant signal; and
a comparator that receives the output signal of the slope generation circuit and the output signal of the analog inversion amplifier as inputs, outputs a high signal when a voltage of the output signal of the slope generation circuit is higher than a voltage of the output signal of the analog inversion amplifier, and outputs a low signal when the voltage of the output signal of the slope generation circuit is lower than the voltage of the output signal of the analog inversion amplifier.

7. A digital audio amplifier comprising:
a digital modulator that converts an input signal to a third 1-bit digital signal; and
a power amplification circuit block that amplifies an output signal of the digital converter, wherein
the power amplification circuit block includes:
an attenuator;
a signal synthesizer that combines the third 1-bit digital signal with an output signal of the attenuator and outputs a resultant synthesized signal;
a D-class amplifier that amplifies an output signal of the signal synthesizer; and
a low-pass filter that removes high frequency noise components from an output signal of the D-class amplifier and outputs a resultant signal,
the attenuator detecting an output signal of the low-pass filter, attenuating the output signal with a preset ratio, and outputting a resultant signal to the signal synthesizer,
the signal synthesizer being a signal synthesis circuit according to any one of claims 1 to 6,
the third 1-bit digital signal being input as the first 1-bit digital signal, and an output signal of the attenuator being input as the analog signal.

8. The digital audio amplifier according to claim 7, wherein
a plurality of the power amplification circuit blocks are mounted in parallel, and
the output signal of the digital converter is input to the plurality of power amplification circuit blocks, and each of the plurality of power amplification circuit blocks amplifies the output signal of the digital converter and outputs a resultant signal.

9. A power supply circuit comprising:
a digital modulator that receives a first distributed signal obtained by separating an input signal as an input and converts the first distributed signal to a third 1-bit digital signal;
a power amplification circuit block that receives a signal obtained by delaying a second distributed signal obtained by separating the input signal and the third 1-bit digital signal as inputs, amplifies the second distributed signal and
the third 1-bit digital signal, then performs power synthesis, and outputs a resultant signal; and
a delay unit that provides the second distributed signal with a time delay as compared with the first distributed signal and outputs a resultant signal to the power amplification circuit block as the signal,
the power amplification circuit block including:
a linear amplifier that receives the delayed second distributed signal as an input, amplifies the delayed second distributed signal, and outputs a resultant signal;
a high-pass filter that receives an output signal of the linear amplifier as an input, removes low frequency components, and outputs a resultant signal;
a current detector that detects a current component from an output signal of the high-pass filter, and outputs the current components;
a first low-pass filter that receives an output signal of the current detector, removes high frequency components, and outputs a resultant signal;
a signal synthesizer that receives the third 1-bit digital signal and an output signal of the first low-pass filter as inputs, combines them, and outputs a resultant synthesized signal;
a switching amplifier that amplifies the output signal of the signal synthesizer; and
a second low-pass filter that removes high frequency noise components from an output signal of the switching amplifier, and outputs a resultant signal, the signal synthesizer being the signal synthesis circuit according to any one of claims 1 to 6,
the third 1-bit digital signal being input as the first 1-bit digital signal, an output signal of the first low-pass filter being input as the analog signal, a cutoff frequency of the high-pass filter being lower in frequency than a cutoff frequency of the second low-pass filter, and
an output signal of the second low-pass filter and the output signal of the high-pass filter being subject to power synthesis and a resultant signal being output.

10. The power circuit according to claim 9, wherein
a plurality of the power amplification circuit blocks are mounted in parallel, the third 1-bit digital signal and the delayed second distributed signal are input to the plurality of power amplification circuit blocks, and
each of the plurality of the power amplification circuit blocks amplifies the third 1-bit digital signal and the delayed second distributed signal and performs power synthesis.

## Amended claims

### Amended claims under Art. 19.1 PCT

**.** laim 1} (Deleted)

**.** laim 2} (Deleted)

**.** laim 3} (Deleted)

**.** laim 4} (Deleted)

**.** laim 5} (Deleted)

**.** laim 6} The signal synthesis circuit according to any one of claims 1 to 4, wherein the 1-bit decision circuit includes:
an analog inversion amplifier that inverts a positive-negative polarity of the analog signal and outputs a resultant signal; and
a comparator that receives the output signal of the slope generation circuit and the output signal of the analog inversion amplifier as inputs, outputs a high signal when a voltage of the output signal of the slope generation circuit is higher than a voltage of the output signal of the analog inversion amplifier, and outputs a low signal when the voltage of the output signal of the slope generation circuit is lower than the voltage of the output signal of the analog inversion amplifier.

**.** laim 7} A digital audio amplifier comprising:
a digital modulator that converts an input signal to a third 1-bit digital signal; and
a power amplification circuit block that amplifies an output signal of the digital converter, wherein
the power amplification circuit block includes:
an attenuator;
a signal synthesizer that combines the third 1-bit digital signal with an output signal of the attenuator and outputs a resultant synthesized signal;
a D-class amplifier that amplifies an output signal of the signal synthesizer; and
a low-pass filter that removes high frequency noise components from an output signal of the D-class amplifier and outputs a resultant signal,
the attenuator detecting an output signal of the low-pass filter, attenuating the output signal with a preset ratio, and outputting a resultant signal to the signal synthesizer,
the signal synthesizer being a signal synthesis circuit according to any one of claims 1 to 6,
the third 1-bit digital signal being input as the first 1-bit digital signal, and an output signal of the attenuator being input as the analog signal.

**.** laim 8} The digital audio amplifier according to claim 7, wherein
a plurality of the power amplification circuit blocks are mounted in parallel, and
the output signal of the digital converter is input to the plurality of power amplification circuit blocks, and each of the plurality of power amplification circuit blocks amplifies the output signal of the digital converter and outputs a resultant signal.

**.** laim 9} A power supply circuit comprising:
a digital modulator that receives a first distributed signal obtained by separating an input signal as an input and converts the first distributed signal to a third 1-bit digital signal;
a power amplification circuit block that receives a signal obtained by delaying a second distributed signal obtained by separating the input signal and the third 1-bit digital signal as inputs, amplifies the second distributed signal and
the third 1-bit digital signal, then performs power synthesis, and outputs a resultant signal; and
a delay unit that provides the second distributed signal with a time delay as compared with the first distributed signal and outputs a resultant signal to the power amplification circuit block as the signal,
the power amplification circuit block including:
a linear amplifier that receives the delayed second distributed signal as an input, amplifies the delayed second distributed signal, and outputs a resultant signal;
a high-pass filter that receives an output signal of the linear amplifier as an input, removes low frequency components, and outputs a resultant signal;
a current detector that detects a current component from an output signal of the high-pass filter, and outputs the current components;
a first low-pass filter that receives an output signal of the current detector, removes high frequency components, and outputs a resultant signal;
a signal synthesizer that receives the third 1-bit digital signal and an output signal of the first low-pass filter as inputs, combines them, and outputs a resultant synthesized signal;
a switching amplifier that amplifies the output signal of the signal synthesizer; and
a second low-pass filter that removes high frequency noise components from an output signal of the switching amplifier, and outputs a resultant signal, the signal synthesizer being the signal synthesis circuit according to any one of claims 1 to 6,
the third 1-bit digital signal being input as the first 1-bit digital signal, an output signal of the first low-pass filter being input as the analog signal, a cutoff frequency of the high-pass filter being lower in frequency than a cutoff frequency of the second low-pass filter, and
an output signal of the second low-pass filter and the output signal of the high-pass filter being subject to power synthesis and a resultant signal being output.

**.** laim 10} (Amended) The power supply circuit according to claim 9, wherein
a plurality of the power amplification circuit blocks are mounted in parallel, the third 1-bit digital signal and the delayed second distributed signal are input to the plurality of power amplification circuit blocks, and
each of the plurality of the power amplification circuit blocks amplifies the third 1-bit digital signal and the delayed second distributed signal and performs power synthesis.

**.** laim 11} (Added) A signal synthesis method comprising:
a first step of generating a slope on an input first 1-bit digital signal during at least one of a time period of transition of the first 1-bit digital signal from high to low and a time period of transition of the first 1-bit digital signal from low to high; and
a second step of causing a high-low decision on the first 1-bit digital signal with the generated slope to vary by using an input analog signal, and
outputting a second 1-bit digital signal generated by the high-low decision, the second 1-bit digital signal being a signal obtained by varying a duty ratio of the first 1-bit digital signal on the basis of the analog signal,
the second step including:
a step of inverting a positive-negative polarity of the analog signal; and
a step of comparing a voltage of the first 1-bit digital signal with the slope generated with a voltage of the analog signal inverted in positive-negative polarity, outputting a high signal when the voltage of the first 1-bit digital signal with the slope generated is higher than the voltage of the analog signal inverted in positive-negative polarity, and outputting a low signal when the voltage of the first 1-bit digital signal with the slope generated is lower than the voltage of the analog signal inverted in positive-negative polarity.

**.** laim 12} (Added) A method of driving a digital audio amplifier, comprising:
a conversion step of converting an input signal to a third 1-bit digital signal; and
a power amplification step of amplifying the third 1-bit digital signal, the power amplification step including:
a synthesis step of combining the third 1-bit digital signal with an input analog signal;
an amplification step of amplifying a signal obtained by the synthesis;
a removal step of removing high frequency noise components from the amplified signal; and
a step of detecting the signal from which the high frequency noise components are removed, attenuating the signal with a preset ratio, and outputting a resultant signal as the analog signal in the synthesis step, and the synthesis step including:
a first step of generating a slope on an input first 1-bit digital signal during at least one of a time period of transition of the first 1-bit digital signal from high to low and a time period of transition of the first 1-bit digital signal from low to high; and
a second step of causing a high-low decision on the first 1-bit digital signal with the generated slope to vary by using an input analog signal, and outputting a second 1-bit digital signal generated by the high-low decision, the second 1-bit digital signal being a signal obtained by varying a duty ratio of the first 1-bit digital signal on the basis of the analog signal,
the third 1-bit digital signal being input as the first 1-bit digital signal, and the analog signal in the synthesis step being input as the analog signal in the signal synthesis method.

**.** laim 13} (Added) The method according to claim 12, wherein a plurality of the power amplification steps are conducted in parallel on the third 1-bit digital signal generated in the conversion step.

**.** laim 14} (Added) A method of driving a power supply circuit, comprising:
a conversion step of converting a first distributed signal obtained by separating an input signal to a third 1-bit digital signal;
a step of providing a second distributed signal obtained by separating the input signal with a time delay as compared with the first distributed signal; and
a power amplification circuit step of amplifying the delayed second distributed signal and the third 1-bit digital signal respectively, then performing power synthesis, and outputting a resultant signal,
the power amplification circuit step including:
a step of amplifying the delayed second distributed signal and outputting a resultant signal;
a step of removing low frequency components of the amplified signal and outputting a resultant signal;
a step of detecting a current component from the signal from which the low frequency components are removed and outputting a resultant signal;
a first removal step of removing high frequency components of the signal after the current component detection;
a signal synthesis step of combining the third 1-bit digital signal with the signal from which high frequency components are removed and outputting a resultant signal;
a step of amplifying the signal after the synthesis; and
a second removal step of removing high frequency noise components from the amplified signal,
the signal synthesis step being conducted by using the signal synthesis method according to claim 11,
the third 1-bit digital signal being input as the first 1-bit digital signal,
the signal with the high frequency components removed in the first removal step being input as the analog signal,
a cutoff frequency in the step of removing low frequency components and outputting a resultant signal being lower in frequency than a cutoff frequency in the second removal step, and
the output signal in the second removal step and the output signal in the step of removing the low frequency components and outputting a resultant signal being subject to power synthesis and a resultant signal being output.

**.** laim 15} (Added) The method according to claim 14, wherein a plurality of the power amplification steps are conducted in parallel on the third 1-bit digital signal generated in the conversion step.
